Europäisches Patentamt

European Patent Office

Office européen des brevets

(11) Publication number: **0 043 099**
**B1**

## (12) EUROPEAN PATENT SPECIFICATION

(45) Date of publication of patent specification: **14.03.84**

(21) Application number: **81104893.3**

(22) Date of filing: **24.06.81**

(51) Int. Cl.³: **H 01 L 31/10,**
**H 01 L 29/36,**
**H 01 L 21/225,**
**H 01 L 21/263**

(54) **Light-activated semiconductor device.**

(30) Priority: **28.06.80 JP 88021/80**

(43) Date of publication of application:
**06.01.82 Bulletin 82/1**

(45) Publication of the grant of the patent:
**14.03.84 Bulletin 84/11**

(84) Designated Contracting States:
**CH DE GB LI SE**

(56) References cited:
**GB - A - 2 033 661**
**US - A - 3 943 549**

**SIXTH EUROPEAN SOLID STATE DEVICE
RESEARCH CONFERENCE, 1976, Bristol and
London GERLACH "Light-activated Power
Thyristors" pages 111 to 133**

(73) Proprietor: **TOKYO SHIBAURA DENKI KABUSHIKI
KAISHA**
**72, Horikawa-cho Saiwai-ku**
**Kawasaki-shi Kanagawa-ken 210 (JP)**

(72) Inventor: **Matsuda, Hideo**
**34-6, Osone-cho**
**Kohoku-ku Yokohama-shi (JP)**

(74) Representative: **Patentanwälte Henkel, Pfenning,
Feiler, Hänzel & Meinig**
**Möhlstrasse 37**
**D-8000 München 80 (DE)**

Courier Press, Leamington Spa, England.

Light-activated semiconductor device

This invention relates to a light-activated semiconductor device and a method of manufacturing the same.

A light-activated semiconductor device, for example, a light-activated thyristor is actuated by a light trigger signal instead of an electric trigger signal capable of being used with the ordinary thyristor. This trigger light is an infrared ray slightly shorter than 1.15 microns corresponding to the energy gap (the energy width of a forbidden band) of silicon constituting a semiconductor substrate. The trigger light is irradiated on the light-receiving section of a light-activated thyristor to generate carriers in the semiconductor substrate. As compared with the ordinary electric triggered thyristor, the above-mentioned light-activated thyristor has the advantage of more easily insulating a control circuit and power circuit. Further, the light-activated thyristor which connects a control circuit and power circuit together by a light has the further advantage of being less affected by noises. Therefore, application of the light-activated thyristor makes it unnecessary to provide an insulation gate transformer, thereby assuring the miniaturization and light weight of a device provided with the light-activated thyristor. The light-activated thyristor which eliminates the occurrence of an erroneous ignition resulting from noises is effectively applicable not only to a logical controlling circuit but also a high voltage device.

Therefore, the research and development of a high voltage-large capacity light-activated thyristor are attempted for use with a D.C. transmission converter. A high voltage thyristor used with a D.C. transmission converter is demanded to have a high critical rate of rise of off-state voltage (dv/dt capability) and a high critical rate of rise of on-state current (di/dt capability) in order to reduce a turnoff time. The turnoff time tq is expressed as follows:

$$tq \simeq \tau \ln \frac{I_F}{I_H}$$

where:

$\tau$=lifetime of a carrier

$I_H$=magnitude of holding current

$I_F$=magnitude of forward current

With a high voltage converter, the turnoff time is demanded to be less than 400 microseconds.

In case of $I_H$=100 milliamperes, and $I_F$=1,000 amperes, then there results

$$400 \text{ microseconds} > \tau \ln \frac{1,000}{0.1}$$

Therefore, $\tau$<40 microseconds should be established.

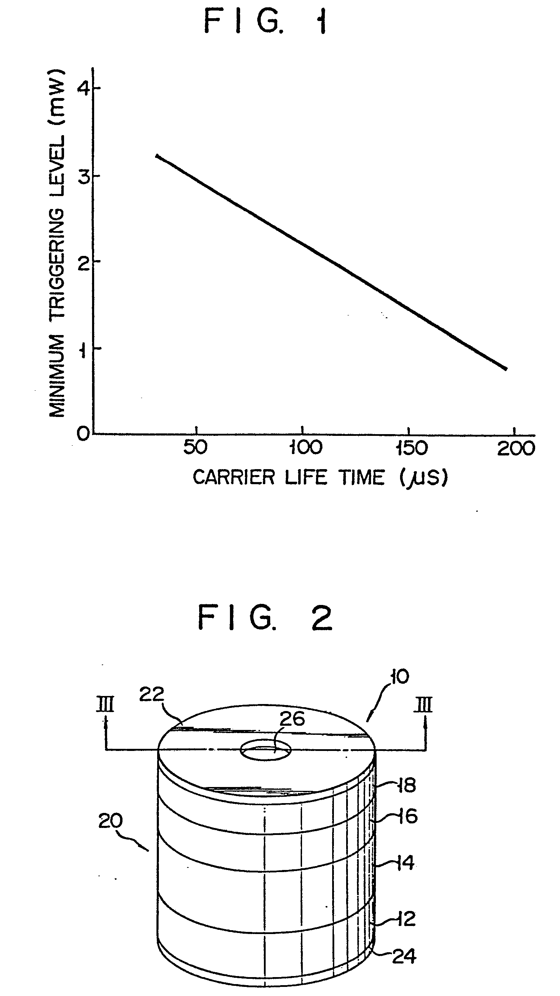

A light source for supplying a trigger signal to a light-activated thyristor may be formed of a sunlight, incandescent lamp, neon lamp, xenon lamp, or light-emitting diode. A GaAs infrared-emitting diode has a wavelength approximating 1 micron which carries out a very effective trigger action for a light-activated thyristor. The above-mentioned diode generally of the extremely miniaturized form can emit a pulsated light trigger signal. Therefore, a light-activated thyristor device assembled with the above-mentioned light-emitting diode can be effectively used with a light-coupling circuit. However, a light-emitting diode in current use fails to produce a large amount of light. Where, therefore, it is attempted to apply the commercially available light-emitting diode as a trigger light source, it is necessary to increase the trigger sensitivity of a light-activated thyristor scores of times over that of an electric trigger thyristor. The lifetime of a carrier has to be prolonged in order to elevate the trigger sensitivity of the light-activated thyristor. Figure 1 shows the relationship between the light trigger sensivity and carrier lifetime of a light-activated thyristor having a certain geometric form and impurity diffusion profile. The light trigger sensitivity is expressed in terms of a minimum quantity of trigger light. Where a carrier lifetime is 50 microseconds, then a minimum trigger light quantity is about 3 milliwatts. Where, however, a carrier lifetime indicates 150 microseconds, then the minimum trigger light quantity is about 1.5 milliwatts, namely, about half the minimum trigger light quantity required when the carrier lifetime is 50 microseconds. As described above, the carrier lifetime should be reduced in order to elevate the critical rate of rise of off-state voltage (dv/dt capability), and be increased in order to raise light trigger sensivity. In other words, the critical rate of rise of off-state voltage (dv/dt capability) is inversely proportional to the light trigger sensitivity.

To date, various light-receiving structures have been proposed for a light-activated thyristor in order to improve trade-off between the light trigger sensitivity and critical rate of rise of off-state voltage (dv/dt capability). Some of the proposed light-receiving structures are disclosed in "Light-activated power thyristors", W. Gerlach, fifth European Solid State Device Res. Conf. pp. 111—133.

Furthermore GB—A—2 033 661 discloses a thyristor actuated by an electric trigger signal. An electron beam illuminates a specific region, thereby to shorten the carrier life time in this region and subsequently to improve the dv/dt capability and reduce the turn-off time. Also US—A—3 943 549 discloses a thyristor actuated by an electric trigger signal. The carrier life time of a portion of a region in which the main-current flows is lengthened in order to improve the turn-on characteristics including di/dt capability and to fire the thyristor without supplying a base current when a voltage higher than the breakover voltage is applied. Thus, the main current flows in this region because it is located below the cathode electrode.

It is accordingly the object of this invention to provide a light-activated semiconductor device which is effectively applicable to large power transmission, and which can elevate the light trigger sensitivity without reducing the aforementioned dv/dt capability.

Another object of the invention is to provide a method of manufacturing the above-mentioned light-activated semiconductor device.

To attain the above-mentioned object, this invention provides a light-activated semiconductor device which comprises a semiconductor body constructed by laminating a plurality of semiconductor layers having alternately different conductivity types, and wherein the semiconductor body has a first region which penetrates the semiconductor body from one side thereof on which a light-receiving section is formed to the opposite side thereof and in which a generated carrier has a long lifetime, and a second region which purposely reduces the lifetime of a generated carrier. In the above mentioned first region, a light trigger sensitivity is increased, and in the second region (conductive region) the aforesaid dv/dt capability is raised.

Thus the invention resolves the aforementioned difficulties by diffusing an impurity in a semiconductor substrate with a particular profile, instead of by improvement on the light-receivng structure of a light-activated thyristor.

Other objects and advantages of the invention will become apparent from the following detailed description when taken in conjunction with the accompanying drawings, in which:

Figure 1 graphically indicates the relationship between the carrier lifetime and minimum triggering level;

Figure 2 is an oblique view of a light-activated thyristor embodying this invention;

Figure 3 is a cross sectional view on line III—III of the light-activated thyristor of Figure 2;

Figures 4a to 4h illustrate the cross sections of the subject light-activated thyristor corresponding to the sequential manufacturing steps;

Figure 5 is an enlarged sectional view of the subject light-activated thyristor given in supplement to the description of the manufacturing method thereof; and

Figures 6a to 6e show the cross sections of the subject light-activated thyristor corresponding to the sequential manufacturing steps different from those of Figure 4.

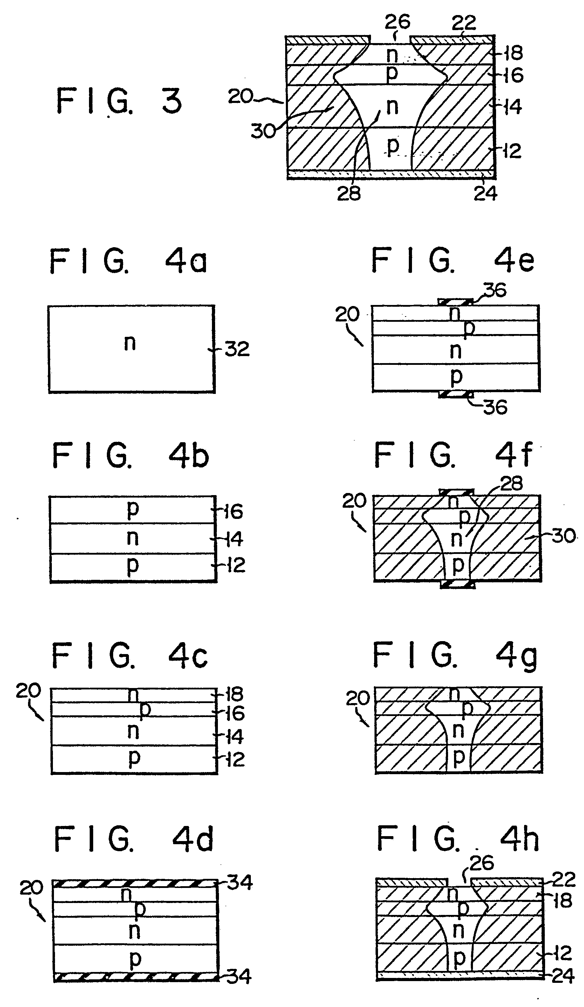

Description is now given with reference to Figures 2 and 3 of a light-activated semiconductor device embodying this invention. A light-activated thyristor 10 comprises: semiconductor body 20 formed of a first p-type semiconductor layer 12 constructed by doping a gallium (Ga) in a silicon (Si) layer of high resistivity, a first n-type semiconductor layer 14 constructed by doping a phosphorus (P) in a silicon (Si) layer, a second p-type semiconductor layer 16 constructed by doping a gallium (Ga) in a silicon (Si) and a second n-type semiconductor layer 18 constructed by doping a phosphorus (P) in a silicon (Si); an aluminum cathode electrode 22; and an aluminum anode electrode 24.

A light-receiving penetrating hole 26 is formed at the center of the aluminum cathode electrode 22; and an aluminum anode electrode 24.

A light-receiving penetrating hole 26 is formed at the center of the aluminum cathode electrode 22. Gold is diffused in the semiconductor body 20 with a prescribed profile as a carrier lifetime killer. Namely, the gold is little diffused in the central portion (light-receiving region) 28 of the semiconductor body 20 which is spread from the exposed portion of the semiconductor body 20 facing the light-receiving pentrating hole 26 to the opposite side of the semiconductor body 20. Gold is selectively diffused as a carrier lifetime killer in the other outer peripheral portion (conductive region) 30 of the semiconductor body 20 than the central portion 28 thereof.

The lift-activated thyristor 10 constructed as described above can provide a different carrier lifetime in the light-receiving region 28 of the penetrating hole 26 from that which is obtained in the conductive region 30 of the cathode electrode 22. Namely, a carrier lifetime is prolonged in the light-receiving region 28, and reduced in the conductive region 30. Therefore, the light trigger sensitivity is elevated in the light-receiving region 28, and the dv/dt capability is increased in the conductive region 30. Once the light-receiving region 28 is actuated, much current does not flow through the region 28, little affecting the turnoff time of the light-activated thyristor 10, even though the carrier lifetime may be long in the light-receiving region 28. Since the light trigger sensitivity can be elevated without reducing the critical rate of rise of off-state voltage (dv/dt capability), it is possible to apply a light source emitting a relatively small quantity of light such as an infrared-emitting diode as light triggering means.

With a 2 kV thyristor, the first n-type semiconductor layer 16 in which a carrier is generated by light should have an impurity concentration of at least $1 \times 10^{14}/cm^3$. In this case, a carrier lifetime in the light-receiving region 28 increases over 100 microseconds.

Figures 4a to 4h indicate the sequential steps of manufacturing a light-activated thyristor embodying this invention. Figure 4a denotes an n-type semiconductor wafer 32 constructed by doping a phosphorus (P) in a silicon (Si) layer of high specific resistivity. Gallium (Ga), for example, is thermally diffused in both sides of the semiconductor wafer 32 to provide a first p-type semiconductor layer 12 and second p-type semiconductor layer 16. A region in which gallium (Ga) is not diffused constitutes a first n-type semiconductor layer 14 (Figure 4b). Thereafter, phosphorus (P), for example, is thermally diffused from the surface of the second p-type semiconductor layer 16 to form a second n-type semiconductor layer 18. Eventually, a semiconductor body 20 (Figure 4c) is formed by superposing layers having alternately arranged p and n conductivity types. Both sides of the semiconductor body 20 are thermally oxidized to form a silicon oxide (SiO$_2$) layer 34 (Figure 4d). The silicon oxide (SiO$_2$) layer 34 is selectively etched by photolithography to provide a silicon oxide layer pattern 36 (Figure 4e). A heavy metal, for example, gold is selectively diffused as a carrier lifetime killer from both sides of the semiconductor body 20 with the silicon oxide layer pattern 36 used as a mask, thereby providing the central portion 28 in which gold is not diffused and the peripheral portion 30 in which gold is diffused (Figure 4f). The silicon oxide layer pattern 36 is removed (Figure 4g). An aluminum cathode electrode 22 having a ligh-receiving penetrating hole 26 is deposited on the surface of the second n-type semiconductor layer 18. An aluminum anode electrode 24 is deposited on the surface of the first p-type semiconductor layer 12. The light-receiving penetrating hole 26 is formed in a region in which gold is not doped (Figure 4h). The diffusion constant of gold in a silicon layer is scores of times larger than that of gold diffusion constant in a silicon oxide (SiO$_2$) layer. Therefore, gold can be selectively diffused with the silicon oxide (SiO$_2$) layer used as a mask (Figure 4h). Therefore, a carrier lifetime only in the. conductive peripheral portion 30 of the semiconductor body 20 in which gold is diffused can be reduced to a prescribed extent, without decreasing a carrier lifetime in the central portion 28 of the semiconductor body 20 which is covered with the silicon oxide layer pattern 36.

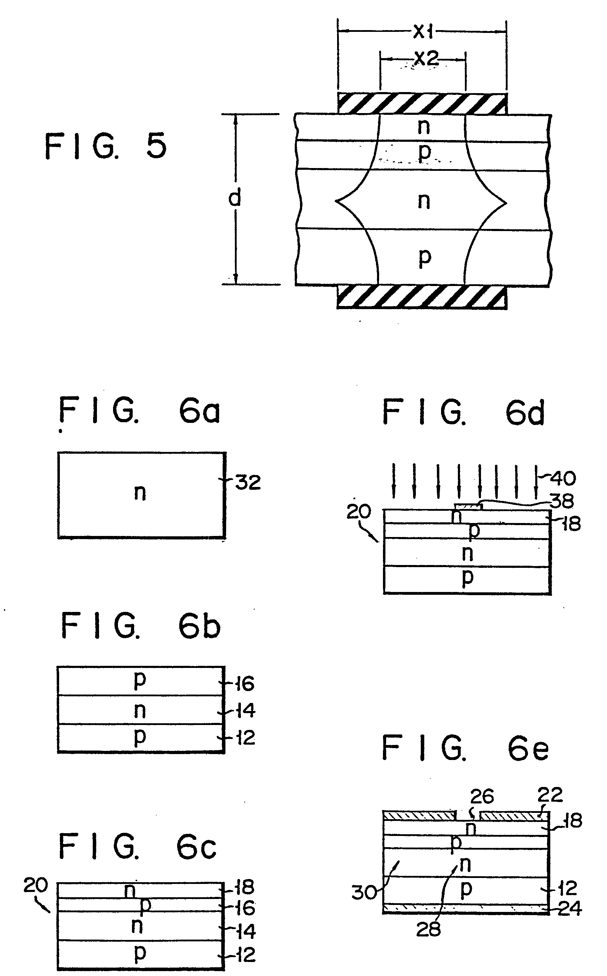

Description is now given with reference to Figure 5 of the process of determining the size of the circular silicon oxide layer pattern 36 used as a mask in manufacturing a light-activated semiconductor device. Now let it be assumed that the diameter of the circular SiO$_2$ pattern mask is represented by x1; the diameter of the light-receiving penetrating hole 26 by x2, and the thickness of the semiconductor wafer 32 by d. Where, gold is diffused from both sides of the wafer 32 to a depth of d/2, then a gold is horizontally diffused to an extent of 0.8×d/2. Therefore, the diameter x1 of the circular SiO$_2$ pattern mask will be sufficient if it is designed as follows:

$$x1 = x2 + 0.8 \cdot \frac{d}{2} \cdot 2 = x2 + 0.8d$$

In other words, it will well serve the purpose if the diameter of the SiO$_2$ pattern mask is made substantially equal to a sum of the diameter of the light-receiving penetrating hole 26 and the thickness d of the semiconductor wafer 32.

Description is now given with reference to Figures 6a to 6e of a different method of manufacturing a light-activated thyristor embodying this invention from that which was previously mentioned. Figure 6a denotes an n-type semiconductor wafer 32 constructed by doping a phosphorus (P) in a silicon (Si) layer of high specific resistivity. Gallium (Ga), for example, is thermally diffused in both sides of the semiconductor wafer 32 to provide a first p-type semiconductor layer 12 and a second p-type semiconductor layer 16. The region of the semiconductor body 20 in which gallium (Ga) is not thermally diffused constitutes a first n-type semiconductor layer 14 (Figure 6b). Thereafter, phosphorus (P), for example, is thermally diffused from the surface of the second p-type semiconductor layer 16 to form a second n-type semiconductor layer 18, eventually providing a semiconductor body 20 consisting of alternately superposed n and p layers (Figure 6c). Then a shield film 38 is formed at the center of the second n-type semiconductor layer 18 to shut off the passage of radiation. This shield film 38 should have a sufficiently great density and thickness to be impervious to radiation. Where, for example, electron beams are applied, then the above-mentioned shield film should preferably be formed of aluminum, lead or wolfram with a greater thickness than 4 or 5 millimeters. Radiation 40, for example, electron beams are irradiated on the semiconductor body 20 in a substantially perpendicular direction with the shield film 38 used as a mask. This procedure does not reduce the carrier lifetime in the light-receiving region below the shielding film 38, but decreases a carrier lifetime in the other conductive region to a prescribed level (Figure 6d). Thereafter, the shield film 38 is removed to form an aluminum cathode electrode 22 having a light-receiving penetrating hole 26 on the surface of the second n-type semiconductor layer 18 and an aluminum, anode electrode 24 on the surface of the first p-type semiconductor layer 12. The light-receiving penetrating hole 26 is formed in that region of the second n-type semiconductor layer 18 from which the shield film 38 was removed (Figure 6e).

As in the first embodiment, the second embodiment of Figures 6a to 6e enables a carrier lifetime only in the conductive peripheral portion 30 of the semiconductor body 20 on which radiation was projected to be reduced to a prescribed level, without decreasing a carrier lifetime in the central portion 28 of the semiconductor body 20 which is covered with the shield film 38.

## Claims

1. A light activated semiconductor device comprising a semiconductor body (20) with a plurality of laminated semiconductor layers (12, 14, 16 and 18) having alternately different conductivity types, a first electrode (22) which is formed on one side of the semiconductor body and which is provided with a light-receiving penetrating hole (26); and a second electrode (24) deposited on the opposite side of the semiconductor body (20), characterized in that said semiconductor body (20) is formed of a first region (28) which is spread from the portion of said semiconductor body (20) below said light-receiving penetrating hole (26) to the opposite side thereof and in which a relatively long carrier lifetime is assured, and a second region (30) other than said first region (28) in which the carrier lifetime is reduced.

2. The light-activated semiconductor device according to claim 1, characterized in that the semiconductor body (20) comprises four semiconductor layers (12, 14, 16, 18) which form a light-activated thyristor.

3. The light activated semiconductor device according to claim 1 or 2, characterized in that the second region (30) in which the carrier lifetime is reduced contains a material acting as a carrier lifetime killer.

4. The light-activated semiconductor device according to claim 3, characterized in that the material acting as a carrier lifetime killer is gold.

5. A method of manufacturing a light-activated semiconductor device characterized by comprising the steps of:

forming an insulation layer (34) on both sides of the semiconductor body (20);
selectively etching the insulation layers (34) to provide masks, the diameter (x1) of each etched insulation layer (36) being made substantially equal to a sum of the diameter of a light-receiving penetrating hole (26) and the thickness (d) of the semiconductor body (20);
diffusing the lifetime killer in the semiconductor body (20) with said etched insulation layers (36) used as masks;
removing the etched insulation layers (36);
forming a first electrode (22) bearing the light-receiving penetrating hole (26) on one side of the semiconductor body (20); and
forming a second electrode (24) all over the opposite side of the semiconductor body (20).

6. The method according to claim 5 characterized in that the material acting as a carrier lifetime killer is gold.

7. A method of manufacturing a light-activated semiconductor device characterized by comprising the steps of:

forming a radiation-shielding film (38) as a mask on at least one side of the semiconductor body (20);
projecting radiation (40) on the semiconductor body (20) in a substantially perpendicular direction with said radiation-shielding film (38) used as a mask, the radiation being such that it reduces the carrier lifetime in the regions which are not below the radiation-shielding film (38)—and thus not in the light-activating regions—to a prescribed level;
removing the radiation-shielding film (38);
forming a first electrode (22) bearing a light-receiving penetrating hole (26) on that region on one side of the semiconductor body (20) from which the radiation-shielding film (38) was removed; and forming a second electrode (24) all over the opposite of the semiconductor body (20).

8. The method according to claim 7 characterized in that the radiation (40) is formed of electron beams.

## Patentansprüche

1. Lichtaktiviertes Halbleiterbauelement, bestehend aus einem Halbleiterkörper (20) mit einer Anzahl laminierter Halbleiterschichten (12, 14, 16 und 18) jeweils abwechselnd unterschiedlicher Leitfähigkeitstypen, einer auf der einen Seite des Halbleiterkörpers ausgebildeten und mit einer Lichtempfangs-Durchgangsöffnung (26) versehenen ersten Elektrode (22) und einer auf die gegenüberliegende Seite des Halbleiterkörpers (20) aufgebrachten zweiten Elektrode (24), dadurch gekennzeichnet, daß der Halbleiterkörper (20) aus einem ersten Bereich (28), der sich von dem unter der Lichtempfangs-Durchgangsöffnung (26) liegenden Abschnitt des Halbleiterkörpers (20) bis zu seiner anderen Seite erstreckt und in welchem eine vergleichsweise lange Trägerlebensdauer sichergestellt ist, und einem zweiten, vom ersten Bereich (28) verschiedenen Bereich (30) gebildet ist, in welchem die Trägerlebensdauer verringert ist.

2. Lichtaktiviertes Halbleiterelement nach Anspruch 1, dadurch gekennzeichnet, daß der Halbleiterkörper (20) vier Halbleiterschichten (12, 14, 16, 18) umfaßt, die einen lichtaktivierten Thyristor bilden.

3. Lichtaktiviertes Halbleiterelement nach Anspruch 1 oder 2, dadurch gekennzeichnet, daß der zweite Bereich mit verringerter Trägerlebensdauer einen als Trägerlebensdauerunterdrücker wirkenden Stoff enthält.

4. Lichtaktiviertes Halbleiterelement nach Anspruch 3, dadurch gekennzeichnet, daß der als Trägerlebensdauerunterdrücker wirkende Stoff Gold ist.

5. Verfahren zur Herstellung eines lichtaktivierten Halbleiterbauelements, dadurch gekennzeichnet, daß auf beiden Seiten des Halbleiterkörpers (20) je eine Isolierschicht (34) ausgebildet wird,

die Isolierschichten (34) zur Formung von Masken selektive geätzt werden, wobei der Durchmesser (x1) jeder geätzten Isolierschicht (36) praktisch gleich der Summe aus dem Durchmesser einer Lichtempfangs-Durchgangsöffnung (26) und der Dicke (d) des Halbleiterkörpers (20) ausgebildet wird,

unter Verwendung der geätzten Isolierschichten (36) als Masken der Lebensdauerunterdrücker in den Halbleiterkörper (20) eindiffundiert wird,

die geätzten Isolierschichten (36) entfernt werden, eine erste, die Lichtempfangs-Durchgangsöffnung (26) enthaltende Elektrode (22) auf der einen Seite des Halbleiterkörpers (20) ausgebildet wird und

über die gesamte gegenüberliegende Seite des Halbleiterkörpers (20) hinweg eine zweite Elektrode (24) ausgebildet wird.

6. Verfahren nach Anspruch 5, dadurch gekennzeichnet, daß als Stoff, der als Trägerlebensdauerunterdrücker wirkt, Gold verwendet wird.

7. Verfahren zur Herstellung eines lichtaktivierten Halbleiterbauelements, dadurch gekennzeichnet, daß auf mindestens einer Seite des Halbleiterkörpers (20) eine Strahlungsabschirmschicht (38) als Maske ausgebildet sind,

unter Verwendung der Strahlungsabschirmschicht (38) also Maske der Halbleiterkörper (20) im wesentlichen senkrecht mit Strahlung (40) bestrahlt wird, die von solcher Art ist, daß sie die Trägerlebensdauer in den nicht unterhalb der Strahlungsabschirmschicht (38)—und damit nicht in den lichtaktivierten Bereichen—liegenden Bereichen auf eine vorgeschriebene Größe verringert,

die Strahlungsabschirmschicht (38) entfernt wird, auf dem Bereich an der einen Seite des Halbleiterkörpers (20), von welcher die Strahlungsabschirmschicht (38) entfernt worden ist, eine mit einer Lichtempfangs-Durchgangsöffnung (26) versehene erste Elektrode (22) ausgebildet wird und

über die gesamte gegenüberliegende Seite des Halbleiterkörpers (20) hinweg eine zweite Elektrode (24) ausgebildet wird.

8. Verfahren nach Anspruch 7, dadurch gekennzeichnet, daß als Strahlung (40) Elektronenstrahlen verwendet werden.

**Revendications**

1. Un dispositif de semi-conducteur excité par la lumière comprenant un corps semi-conducteur (20) constitué d'une pluralité des couches semi-conductrices laminées (12, 14, 16 et 18) ayant alternativement des types de conductivité differents, une première électrode (22) disposée à une face du corps semi-conducteur et équipée d'un trou pénétrant (26) qui fonctionne comme capteur de lumière et une deuxième électrode (24) disposée à la face opposée du corps semi-conducteur (20), caractérisé en ce que ledit corps semi-conducteur (20) est constitué par une première région (28) qui s'étend de la portion du corps semi-conducteur (20) sous ledit trou pénétrant (26) qui fonctionne comme capteur de lumière à la face opposée du corps semi-conducteur et dans laquelle la durée de vie des porteurs de la charge électrique relativement longue est assurée et une deuxième région (30), de nature différente de la première région (28), dans laquelle la durée de vie des porteurs de la charge électrique est diminuée.

2. Le dispositif de semi-conducteur excité par la lumière selon la revendication 1, caractérisé en ce que le corps semi-conducteur contient quatre couches semi-conductrices (12, 14, 16, 18) qui forment un thyristor excité par la lumière.

3. Le dispositif de semi-conducteur excité par la lumière selon la revendication 1 ou 2, caractérisé en ce que la deuxième région (30) dans laquelle la durée de vie des porteurs de la charge électrique est diminuée contient une matière qui agit comme un tueur ("Killer") de la durée de vie des porteurs de la charge électrique.

4. Le dispositif de semi-conducteur excité par la lumière selon la revendication 3, caractérisé en ce que la matière agissante comme un tueur de la durée de vie des porteurs de la charge électrique est l'or.

5. Un procédé de fabrication d'un dispositif de semi-conducteur excité par la lumière, caractérisé en ce que ledit procédé comprend les pas de:

— la formation d'une couche isolante (34) aux deux faces du corps semi-conducteur (20);

— la morsure sélective des couches isolantes (34) pour former des masques, le diamètre (x1) de chaque couche isolante mordée (36) est fait substantiellement équivalent d'une somme du diamètre d'un trou pénétrant (26) qui fonctionne comme capteur de lumière et l'épaisseur (d) du corps semi-conducteur (20);

— la diffusion de la matière agissante comme un tueur des porteurs de la charge électrique dans le corps semi-conducteur (20) portant les couches isolantes (36) utilisées à titre des masques;

— l'enlèvement des couches isolantes mordées;

— la formation d'une première électrode (22) portante le trou pénétrant (26) qui fonctionne comme capteur de la lumière à une face du corps semi-conducteur (20); et

— la formation d'une deuxième électrode (24) à toute la face opposée du corps semi-conducteur (20).

6. Le procédé selon la revendication 5, caractérisé en ce que la matière agissante comme un tueur de la durée de vie des porteurs de charge électrique est l'or.

7. Un procédé de fabrication d'un dispositif de semi-conducteur excité par la lumière, caractérisé en ce que ledit procédé comprend les pas de:

— la formation d'un film protecteur (38) contre l'irradation à titre d'un masque au moins à une face du corps semi-conducteur (20);

— la projection d'irradation (40) au corps semi-conducteur (20) en direction substantiellement perpendiculaire due film protecteur (38) utilisé à titre d'un masque où l'irradation est dosée au point de diminuer la durée de vie des porteurs de charge électrique dans cettes régions qui ne sont pas sous le film protecteur (38);

— et en conséquence pas dans les régions excitantes par la lumière—au niveau prescrit;

— l'enlévement du film protecteur (38) contre l'irradation;

— la formation d'une première électrode (22) portante le trou pénétrant (26) qui fonctionne comme capteur de la lumière à ladite région à une face du corps semi-conducteur dont le film protecteur (38) contre l'irradation était enlevé; et

— la formation d'une deuxième électrode (24) à toute la face opposée du corps semi-conducteur (20).

8. Le procédé selon la revendication 7, caractérisé en ce que l'irradation est formée par les rayons électroniques.

# F I G. 1

# F I G. 2

1

FIG. 3

FIG. 4a

FIG. 4b

FIG. 4c

FIG. 4d

FIG. 4e

FIG. 4f

FIG. 4g

FIG. 4h

FIG. 5

FIG. 6a

FIG. 6b

FIG. 6c

FIG. 6d

FIG. 6e